# EUROPÄISCHE PATENTSCHRIFT

(11) **EP 3 427 557 B1**
(45) Veröffentlichungstag und Bekanntmachung des Hinweises auf die Patenterteilung: **06.04.2022**
(21) Anmeldenummer: 17707238.6
(22) Anmeldetag: 23.02.2017
(51) Int. Cl.: F16H 57/00, H05K 5/00, F16H 61/00

(54) **STEUERGERÄT**
CONTROL UNIT
APPAREIL DE COMMANDE

(30) Priorität: 08.03.2016 DE 102016203718
(43) Veröffentlichungstag der Anmeldung: 16.01.2019
(73) Patentinhaber: ZF Friedrichshafen AG, 88046 Friedrichshafen (DE)
(72) Erfinder: LOIBL, Josef, 93077 Bad Abbach (DE); BRAUN, Christoph, 88690 Uhldingen-Muehlhofen (DE)
(74) Vertreter: ZF Friedrichshafen AG
(86) Internationale Anmeldenummer: PCT/EP2017/054112
(87) Internationale Veröffentlichungsnummer: WO 2017/153174

(56) Entgegenhaltungen:
- DE-A1- 10 134 053
- DE-A1- 19 848 732
- DE-A1-102006 001 890
- DE-C1- 4 334 595
- US-A- 5 909 915
- US-A1- 2006 075 848
- US-B1- 6 307 749

## Beschreibung

Die vorliegende Erfindung betrifft ein Steuergerät gemäß dem Oberbegriff des Patentanspruchs 1.

Die Steuerung von Funktionen eines Fahrzeugs, z.B. die Steuerung von Automatikgetrieben, Lichtfunktionen, Motorfunktionen etc. erfolgt immer häufiger über Steuergeräte, z.B. elektronische Steuergeräte wie beispielsweise elektronische Getriebesteuerungen und ähnliche sogenannte ECU's (aus dem Englischen: electronic control unit). Aus dem Stand der Technik sind integrierte Steuergeräte, sowie Anbau- und Wegbau-Steuergeräte bekannt. Anbau- und Wegbausteuergeräte haben den Vorteil, dass sie durch eine geringe Anzahl an Komponenten für das Steuergerät selbst relativ günstig in der Entwicklung und Herstellung sind. Allerdings werden zusätzliche Komponenten benötigt, um eine Steuerung z.B. eines Fahrzeugs zu ermöglichen. Diese Komponenten sind beispielsweise Kabel, Kabelbäume oder Steckverbindungen.

Elektronische Steuergeräte unterliegen außerdem dauerhaft dem Trend, bei gleichbleibendem oder steigendem Funktionsumfang im Preis immer günstiger zu werden bzw. werden zu müssen. Dies erfordert eine Weiterentwicklung bestehender Lösungen oder den Einsatz neuartiger Konzepte.

In aktuellen Serienanwendungen werden Steuergeräte mit klassischem Aufbau, d.h. ein bestückter Schaltungsträger mit Gehäuse und Stecker, als Anbau(steuer)gerät an einem Aggregat, z.B. einem Automatikgetriebe, verschraubt. Über zwei Steckverbindungen werden zwei Kabelsätze zum Getriebe und zum Fahrzeug verbunden. Getriebeseitig wird wiederum über eine Steckverbindung die Anbindung an Komponenten im Getriebeinnenraum, z.B. Sensoren, Ventile, Motoren, hergestellt. Die Kabelsätze stellen hierbei einen nennenswerten Kostenblock in diesem System dar.

Aus DE 199 55 603 C1 ist ein im Inneren eines Getriebegehäuses angeordnetes Getriebesteuergerät bekannt, bei dem auf einer flexiblen Leiterplatte eine Steckeranordnung angeordnet ist, die mit einem Steckverbinder in eine Gehäuseöffnung des Getriebes eingesetzt wird. Weiterer Stand der Technik ist aus den deutschen Patentanmeldungen DE10134053A1 und DE19848732A1, sowie aus dem US-Patent US6307749B1 bekannt. US2006/075848 A1 offenbart ein Getriebegehäuse.

Ein Durchgangsloch geht durch das Getriebegehäuse. Eine Drucksteuereinheit ist in dem Gehäuse untergebracht und steuert den einem Getriebemechanismus zugeführten Hydraulikdruck durch die Betätigung eines Magnetventils. Im Gehäuse ist ein internes Kabel untergebracht, das elektrisch mit dem Magnetventil des Druckregelgerätes verbunden ist. Ein externes Kabel ist mit einem Motorsteuergerät außerhalb des Gehäuses elektrisch verbunden. Ein Verbinder ist so angeordnet, dass er durch das Durchgangsloch verläuft und elektrisch mit dem internen Kabel und dem externen Kabel verbunden ist. Der Verbinder weist einen äußeren freiliegenden Abschnitt auf, der außerhalb des Gehäuses freiliegt und so ausgebildet ist, dass er durch das Durchgangsloch hindurchgehen kann.

Deshalb ist es eine Aufgabe dieser Erfindung, ein Aufbaukonzept für elektronische Steuergeräte bereitzustellen, das die oben genannten Probleme löst. Speziell soll der konstruktive Aufbau inklusive des Umfangs der Verkabelung deutlich vereinfacht werden.

Diese Aufgabe wird erfindungsgemäß durch die Merkmale des unabhängigen Patentanspruchs gelöst. Vorteilhafte Ausgestaltungen sind Gegenstand der abhängigen Ansprüche.

Vorgeschlagen wird erfindungsgemäß ein Steuergerät, insbesondere Getriebesteuergerät, das dazu eingerichtet ist, auf einer Außenseite oder einen Innenseite eines Gehäuses, insbesondere eines Getriebegehäuses, an der Gehäuseoberfläche 200 anliegend zu werden, wobei das Steuergerät eine Leiterplatte sowie zumindest einen auf der Leiterplatte angeordneten und direkt mit seinen Pins mit korrespondierenden Leiterbahnen der Leiterplatte verbundenen Stecker umfasst, der dazu eingerichtet ist, durch eine Öffnung in dem Gehäuse zu ragen und über an der Leiterplatte angeordnete Leiterbahnen eine elektrische und/oder Signal-Verbindung zwischen der Außenseite und der Innenseite des Gehäuses herzustellen, wobei eine Umspritzung zumindest die Leiterplatte und den bzw. die Stecker umgibt.

In einer Ausgestaltung ist das Steuergerät an der Außenseite des Gehäuses angeordnet und der Stecker ist ein getriebeseitiger Stecker. Vorteilhafterweise weist die Leiterplatte auf der dem getriebeseitigen Stecker gegenüber liegenden Seite einen fahrzeugseitigen Stecker auf, der über die Leiterbahnen mit dem getriebeseitigen Stecker verbunden ist.

In einer alternativen Ausgestaltung ist das Steuergerät an der Innenseite des Gehäuses angeordnet und der Stecker ist ein fahrzeugseitiger Stecker. Vorteilhafterweise weist die Leiterplatte auf der dem fahrzeugseitigen Stecker gegenüber liegenden Seite einen getriebeseitigen Stecker auf, der über die Leiterbahnen mit dem fahrzeugseitigen Stecker verbunden ist. In einer weiteren alternativen Ausgestaltung sind die mit dem fahrzeugseitigen Stecker verbundenen Leiterbahnen der Leiterplatte vorteilhafterweise direkt mit getriebeseitigen Komponenten verbunden.

Vorteilhafterweise erfolgt die Verbindung zwischen Leiterbahnen und Komponenten im Gehäuseinnenraum mittels Löten, Einpressen, Verschweißen und/oder die Komponenten im Gehäuseinnenraum umfassen Signalanbindungen, insbesondere Busanbindungen, insbesondere von Sensoren, Aktoren, Ventile und/oder Motoren, und/oder eine Spannungs- bzw. Stromversorgung.

Durch die Anordnung, dass ein Stecker des Steuergeräts durch eine in dem Gehäuse vorhandene Öffnung die Außenseite des Gehäuses mit der Innenseite verbindet, ermöglicht nicht nur die Einsparung von Kabelsträngen, sondern schafft auch mehr Platz zur Verbauung weiterer Komponenten. Durch die Möglichkeit, das Steuergerät flexibel innen oder außen am Gehäuse anzubringen, kann auf individuelle Einbausituationen eingegangen und sogar bereits vorhandene Systeme nachgerüstet werden.

Vorteilhafterweise umgibt eine Umspritzung zumindest die Leiterplatte und den bzw. die Stecker, um Schutz vor äußeren Einflüssen zu gewährleisten.

Vorteilhafterweise umgibt den durch die Öffnung des Gehäuses ragende Stecker eine Dichtung, insbesondere ein oder mehrere O-Ringe oder eine in einer Ausnehmung der Umspritzung angeordnete Formdichtung, um eine zusätzliche Abdichtung vor z.B. Flüssigkeiten, zu gewährleisten.

Vorteilhafterweise umfasst die Leiterplatte darauf angeordnete elektrische und/oder elektronische Bauelemente, und in dem Bereich der elektrischen und/oder elektronischen Bauelemente auf der Seite der Leiterplatte, die dem Gehäuse zugewandt ist, ist eine Kühleinrichtung, insbesondere eine Kühlplatte, angeordnet. Durch die direkt an dem Gehäuse anliegende Kühlplatte kann eine effiziente Wärmeableitung auch über das Gehäuse erfolgen, so dass die der elektrischen und/oder elektronischen Bauelemente besser vor einer Beschädigung durch Wärme geschützt sind.

Weitere Merkmale und Vorteile der Erfindung ergeben sich aus der nachfolgenden Beschreibung von Ausführungsbeispielen der Erfindung, anhand der Figuren der Zeichnung, die erfindungsgemäße Einzelheiten zeigt, und aus den Ansprüchen. Die einzelnen Merkmale können je einzeln für sich oder zu mehreren in beliebiger Kombination bei einer Variante der Erfindung verwirklicht sein.

Bevorzugte Ausführungsformen der Erfindung werden nachfolgend anhand der beigefügten Zeichnung näher erläutert.
Fig. 1 zeigt eine Ansicht eines an einem Getriebegehäuse verbauten Steuergeräts gemäß dem Stand der Technik.
Fig. 2 zeigt eine Draufsicht eines Steuergeräts von einer Seite gemäß einer Ausführung der vorliegenden Erfindung.
Fig. 3 zeigt eine Draufsicht eines Steuergeräts von einer der in Fig. 2 gezeigten Seite gegenüber liegenden Seite gemäß einer Ausführung der vorliegenden Erfindung.
Fig. 4 zeigt eine Draufsicht eines Steuergeräts von einer in Fig. 3 gezeigten Seite einer weiteren Ausführung der vorliegenden Erfindung.
Fig. 5 zeigt eine Schnittdarstellung durch die Punkte A-A aus Figuren 2 und 3 eines an einem Getriebegehäuse verbauten Steuergeräts gemäß einer Ausführung der vorliegenden Erfindung.
Fig. 6 zeigt eine Schnittdarstellung durch die Punkte A-A aus Figuren 2 und 4 eines an einem Getriebegehäuse verbauten Steuergeräts gemäß einer weiteren Ausführung der vorliegenden Erfindung.
Fig. 7 zeigt eine Schnittdarstellung durch die Punkte A-A aus Figuren 2 und 3 eines an einem Getriebegehäuse verbauten Steuergeräts gemäß einer weiteren Ausführung der vorliegenden Erfindung.
Fig. 8 zeigt eine wie in Fig. 7 gezeigte Schnittdarstellung eines an einem Getriebegehäuse verbauten Steuergeräts gemäß einer alternativen Ausführung der vorliegenden Erfindung.

In den nachfolgenden Figurenbeschreibungen sind gleiche Elemente bzw. Funktionen mit gleichen Bezugszeichen versehen.

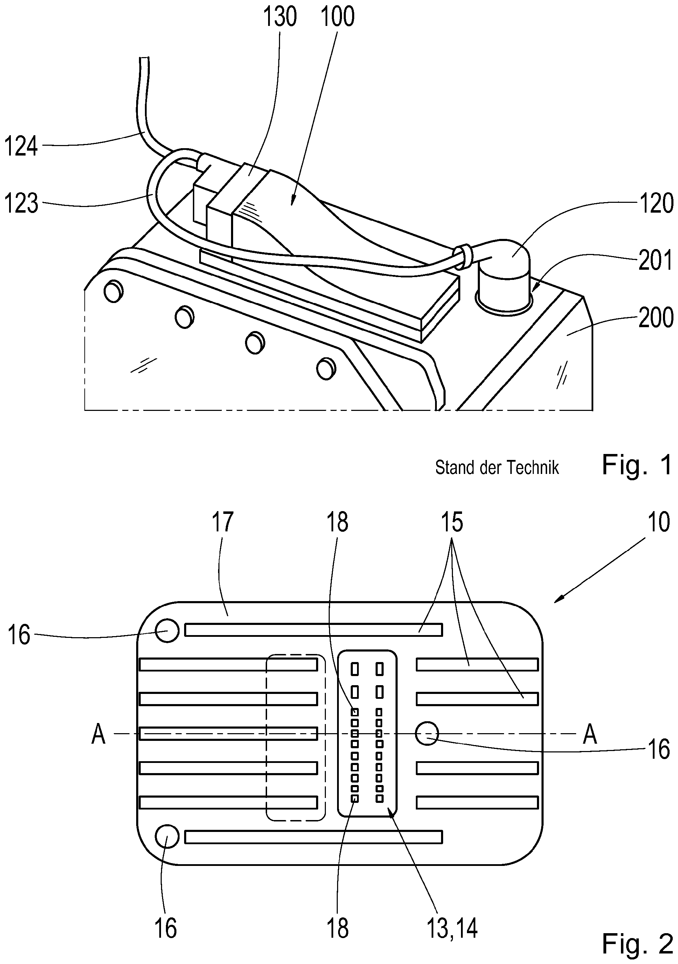

Fig. 1 zeigt eine Ansicht eines an einem Getriebegehäuse 200 verbauten Steuergeräts 100 gemäß dem Stand der Technik. Das Steuergerät 100 ist in der Regel ein bestückter Schaltungsträger mit Gehäuse und Stecker 130 und ist z.B. als Anbausteuergerät 100 an einem Aggregat, z.B. einem Automatikgetriebe, bzw. einem entsprechenden Gehäuse 200 verschraubt. Dabei werden über zwei Steckverbindungen am Stecker 130 zwei Kabelsätze zum Getriebe 123 und zum Fahrzeug 124 verbunden. Getriebeseitig wird wiederum über eine Steckverbindung 120 die Anbindung an Komponenten im Getriebeinnenraum, z.B. Sensoren, Ventile, Motoren, über die Steckeröffnung 201 im Gehäuse 200 hergestellt.

Die Grundidee der vorliegenden Erfindung ist es, ein Aufbaukonzept für ein Steuergerät 100 zu wählen, bei dem das Steuergerät sehr nahe an einer Steckeröffnung 201 eines Aggregats, z.B. eines Automatikgetriebes oder eines anderen Getriebes, bzw. eines Getriebegehäuses 200 an dessen Außen- oder Innenseite verbaut wird. Es kann auch eine zusätzliche Öffnung in das Gehäuse eingebracht werden, wenn z.B. keine der vorhandenen Öffnungen verendet werden kann. Im Steuergerät sind sowohl der getriebe- als auch der fahrzeugseitige Stecker bzw. Kabelsätze integriert. Die Elektronik kann durch Technologien mit minimalem Platzbedarf, z.B. durch einen hochintegrierten Chipsatz auf einer Leiterplatte, aufgebaut werden, so dass ein sehr kompaktes Steuergerät entsteht, das sehr wenig Bauraum benötigt.

Es wird insbesondere ein Einsatz als Anbaugerät am oder als integriertes Modul im Getriebe betrachtet.

Fig. 2 zeigt eine Draufsicht eines Steuergeräts 10 von einer Seite gemäß einer Ausführung der vorliegenden Erfindung. In dieser Ausführungsform kann das Steuergerät 10 von außen oder von innen auf das Gehäuse 200, z.B. ein Getriebegehäuse, angebracht werden.

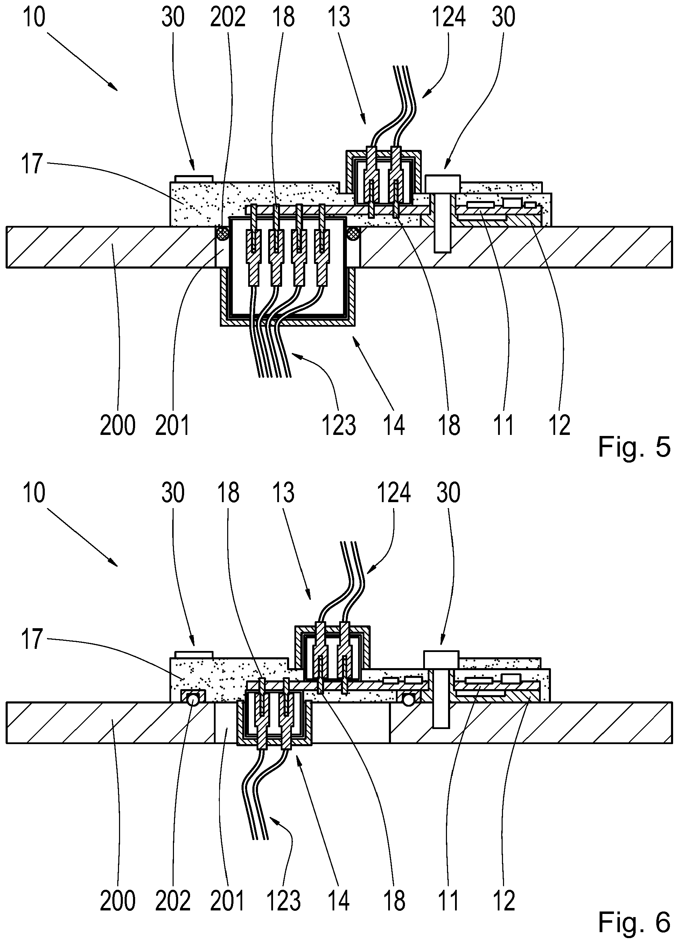

In der Ausführung, bei der das Steuergerät 10 außen an dem Gehäuse 200 angeordnet ist, d.h. auf der Seite außerhalb des Getriebes, d.h. fahrzeugseitig, ist die gezeigte Seite des Steuergeräts dabei die der Gehäuseoberfläche 200 abgewandte Seite, d.h. der Stecker ist der fahrzeugseitige Stecker 13. Dies ist in Figuren 5 und 6 gezeigt und später beschrieben.

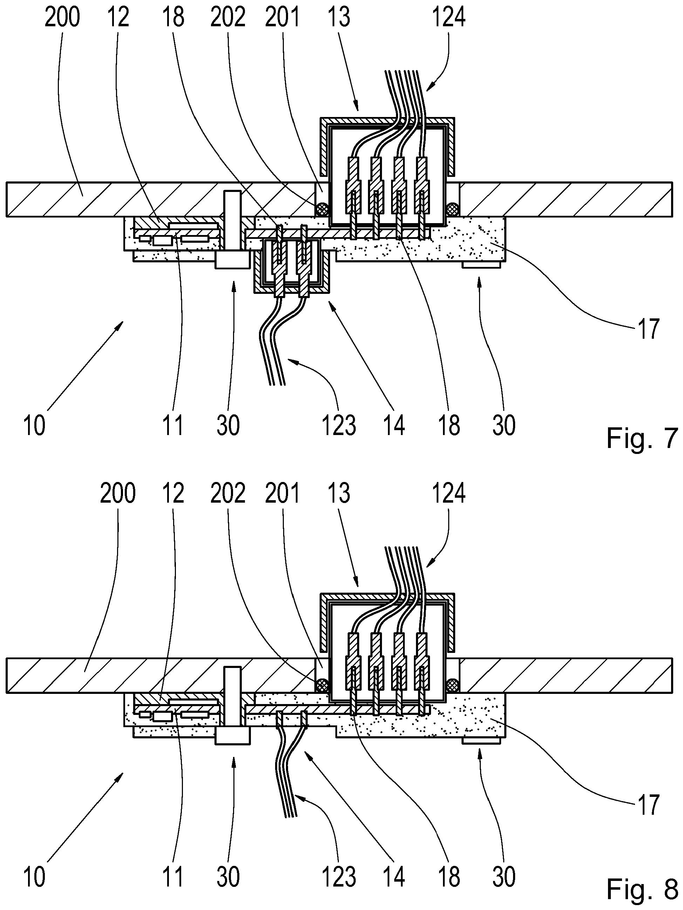

In der Ausführung, bei der das Steuergerät 10 innen an dem Gehäuse 200 angeordnet ist, d.h. auf der Seite innerhalb des Getriebes, d.h. getriebeseitig, ist die gezeigte Seite des Steuergeräts dabei ebenfalls die der Gehäuseoberfläche 200 abgewandte Seite, d.h. der Stecker ist der getriebeseitige Stecker 14. Diese Ausführung ist beispielhaft in Fig. 7 gezeigt. Fig. 8_zeigt eine Ausführung, bei der kein getriebeseitiger Stecker verwendet wird, sondern die getriebeseitigen Komponenten direkt mit der Leiterplatte verbunden sind.

Nachfolgend wird der allgemeine Aufbau des Steuergeräts 10 beschrieben, der sowohl für die Ausführungen anwendbar ist, bei denen das Steuergerät außen am Gehäuse angebracht ist, als auch für diejenigen, bei denen das Steuergerät innen am Gehäuse angebracht ist.

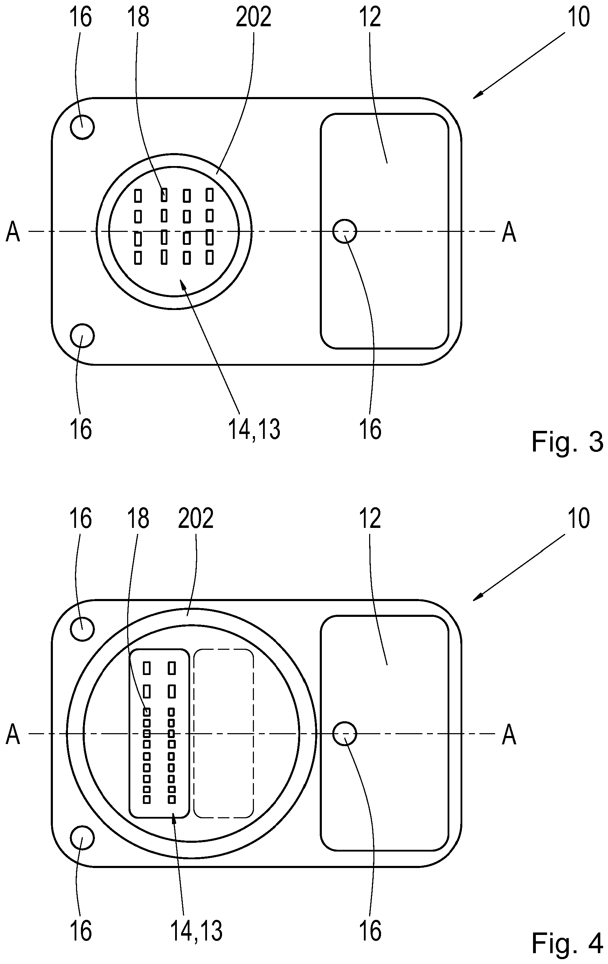

Die in Fig. 2 gezeigte Seite des Steuergeräts 10 weist einen Stecker 13 oder 14 mit entsprechenden Pins 18 auf, der einen entsprechenden Gegenstecker aufnehmen kann. Die Anordnung des Steckers 13 oder 14 ist derart gewählt, dass er nicht dem in Fig. 3 gezeigten Stecker 13 oder 14 direkt gegenüber liegt, d.h. die Stecker würden sich gegenseitig behindern, aber dennoch vorteilhafterweise kurze Verbindungswege über z.B. Leiterbahnen zwischen den Steckern 13 und 14 realisiert werden können. Die Anordnung des in Fig. 2 gezeigten Steckers 13 oder 14 hängt von der Bauform und dem Platzbedarf sowie der Anwendung ab und wird vom Fachmann entsprechend vorgegeben.

Ferner weist die in Fig. 2 gezeigte Seite des Steuergeräts Bohrungen bzw. Anschraubpunkte 16 auf, um das Steuergerät an dem Gehäuse 200 zu verschrauben. Die Anzahl der Bohrungen sollte derart gewählt werden, dass eine stabile Verbindung zwischen Steuergerät 10 und Gehäuse 200 entsteht. Dafür sind beispielsweise drei Bohrungen 16 geeignet, es können aber auch lediglich zwei oder vier oder mehr Bohrungen 16 gewählt werden. Dies ist wiederum vom Fachmann entsprechend der Anwendung zu wählen.

Ferner ist die Leiterplatte des Steuergeräts 10 inklusive dem Stecker mit einer Umspritzung 17 versehen, um einen Schutz vor äußeren Einflüssen zu gewährleisten und um gleichzeitig zumindest eine minimale Versteifung zu bieten. Das Material der Umspritzung 17 sollte derart gewählt werden, dass es eine sichere Dichtung vor Flüssigkeiten, insbesondere Öl, aufweist. Ein geeignetes Material für eine solche Umspritzung 17 ist beispielsweise ein Duroplast.

Ferner sind in dieser Ausführung mehrere Versteifungsrippen 15 auf der gezeigten Seite des Steuergeräts 10 bzw. innerhalb oder auf der Umspritzung 17 angeordnet. Es können zur Versteifung auch andere Strukturen als die gezeigten Rippen ausgebildet werden. Die Rippen können auf die Umspritzung aufgesetzt oder in der Umspritzung 17 integriert werden. Alternativ ist eine Versteifung auch durch ein zusätzliches Fixierblech möglich, das beim Verschrauben des Steuergeräts 10 an dem Gehäuse 200 befestigt wird.

Wie später mit Bezug auf Figuren 7 und 8 genauer beschrieben, muss bei der Ausführung, bei der das Steuergerät 10 innerhalb des Gehäuses 200 angeordnet ist, kein getriebeseitiger Stecker 14 vorhanden sein. Es können vielmehr die im Getrieberaum vorhandenen Komponenten wie z.B. die BUS-Komponenten oder die Stromversorgung, direkt an den Leiterbahnen der Leiterplatte befestigt werden, z.B. durch Löten, Einpressen oder andere bekanntem, geeignete Verfahren.

Fernern kann bei dem fahrzeugseitigen Stecker 13 aus Kostengründen eine Anzahl der Pins 18 auf ein Minimum reduziert werden, z.B. auf zwei Pins für die Spannungsversorgung und zwei Pins für die Busanbindung. Je nach Konfiguration können beispielsweise runde oder rechteckige Stecker mit Rundpins oder rechteckigen Pins verbaut werden. Die Anzahl der Pins 18 und die Art des Steckers 13 sind je nach Platzbedarf und Anwendung vom Fachmann wählbar. Die Anbindung der Pins zur Leiterplatte kann z.B. durch Löten oder Einpressen erfolgen.

Fig. 3 zeigt eine Draufsicht eines Steuergeräts 10 von einer der in Fig. 2 gezeigten Seite gegenüber liegenden Seite gemäß einer Ausführung der vorliegenden Erfindung. In dieser Ausführungsform kann das Steuergerät 10 von außen oder von innen auf das Gehäuse 200, z.B. ein Getriebegehäuse, angebracht werden.

In der Ausführung, bei der das Steuergerät 10 außen an dem Gehäuse 200 angeordnet ist, d.h. auf der Seite außerhalb des Getriebes, also fahrzeugseitig, ist die in Fig. 3 gezeigte Seite des Steuergeräts 10 dabei die der Gehäuseoberfläche 200 zugewandte Seite, d.h. diese Seite liegt auf der Oberfläche des Gehäuses 200 auf, wobei der getriebeseitige Stecker 13 durch die Öffnung 201 im Gehäuse 100 hindurchragt. Dies ist in Figuren 5 und 6 gezeigt und später beschrieben.

In der Ausführung, bei der das Steuergerät 10 innen an dem Gehäuse 200 angeordnet ist, d.h. auf der Seite innerhalb des Getriebes, d.h. getriebeseitig, ist die gezeigte Seite des Steuergeräts dabei ebenfalls die der Gehäuseoberfläche 200 zugewandte Seite, wobei hier der fahrzeugseitige Stecker 13 durch die Öffnung 201 im Gehäuse 100 hindurchragt. Diese Ausführung ist beispielhaft in Figuren 7 und 8 gezeigt.

Die in Fig. 3 gezeigte Seite des Steuergeräts 10 weist einen Stecker auf, der einen entsprechenden Gegenstecker aufnehmen kann. Die Anordnung des Steckers ist derart gewählt, dass er nicht dem in Fig. 2 gezeigten Stecker direkt gegenüber liegt, diesen also nicht behindert, aber dennoch kurze Verbindungswege über z.B. Leiterbahnen zwischen den beiden Steckern 13 und 14 realisiert werden können. Wie bereits oben erwähnt hängt die Anordnung des Steckers von der Bauform und dem Platzbedarf sowie der Anwendung ab und wird vom Fachmann entsprechend vorgegeben.

Es können bei jeder der Ausführungen beide Stecker 13 und 14, also der getriebe- und der fahrzeugseitige Stecker, derart gewählt werden, dass beide so nahe aneinander angeordnet sind, dass sie innerhalb des Bereichs der Bohrung für die Steckeröffnung 201 im Getriebegehäuse 200 liegen, wie in Figuren 2 und 4 als gestrichelte Linie gezeigt und in Fig. 6 im Schnitt zu sehen, so dass weiterer Platz eingespart werden kann. Diese Ausführung der Stecker 13 und 14 kann auch für die Ausführung des Steuergeräts 10, das an der Innenseite des Gehäuses 200 angeordnet ist, gewählt werden und wird in den Figuren nicht gezeigt.

Vorteilhafterweise wird die Form des Steckers 13 oder 14 derart gewählt, dass er in eine in dem Getriebegehäuse 200 vorhandene Öffnung, z.B. die in Fig. 1 gezeigte, Öffnung für den Getriebestecker 201 nach dem Stand der Technik passt, der Stecker 14 also eine runde Form aufweist. Alternativ kann stattdessen der Stecker 13 und/oder 14 auch eine rechteckige Form oder eine andere geeignete Form aufweisen und derart platziert sein, dass der fahrzeugseitige Stecker 13 auf der anderen Seite des Steuergeräts direkt neben dem Stecker 14 innerhalb der vorhandenen Bohrung bzw. Öffnung im Getriebegehäuse 200 angeordnet sein kann, wie in Figuren 2 und 4 gezeigt. Hierdurch erfolgt eine Platzeinsparung. Die Wahl der Form des Steckers 13 und 14 ist abhängig von der Anwendung. Je nach Konfiguration können Stecker mit Rundpins oder rechteckigen Pins verwendet werden. Die Anzahl und die Art der Pins, sowie die Art bzw. Form des Steckers 13 und 14 sind je nach Platzbedarf und Anwendung vom Fachmann wählbar. Die Anbindung der Pins zur Leiterplatte kann z.B. durch Löten oder Einpressen erfolgen.

In Figuren 3 und 4 ist ferner jeweils eine Dichtung 202 gezeigt, die als Formdichtung oder als kostengünstiger O-Ring ausgeführt sein kann, um eine Abdichtung des Steckers 13 oder 14 zusätzlich zur Umspritzung 17 bzw. zwischen der Öffnung 201 im Getriebegehäuse 200 und den darin angeordneten Bauelementen, z.B. dem fahrzeugseitigen und/oder dem getriebeseitigen Stecker 13 bzw. 14, sicherzustellen. Die Art der Dichtung 202 wird je nach Art bzw. Form des Steckers gewählt. Bei einem runden Stecker können einer oder mehrere O-Ringe als Dichtung 202 verwendet werden. Bei einem Stecker, der eine andere Form aufweist als rund, z.B. rechteckig, kann eine Ausnehmung in der Umspritzung 17 außerhalb der Öffnung 201 im Gehäuse gebildet werden, in die eine Formdichtung eingefügt wird. Die Formdichtung kann in die Ausnehmung eingespritzt werden oder als ein Bauteil darin angeordnet werden. Sie sollte aus einem anderen Material als die Umspritzung bestehen, bevorzugt elastisch sein. Je nachdem, welche Art an Steckern gedichtet werden müssen, kann somit eine axiale oder radiale Dichtung erfolgen.

Allerdings kann je nach Anwendung auch keine zusätzliche Abdichtung des Steckers erwünscht oder nötig sein.

In Figuren 3 und 4 sind ebenfalls Bohrungen 16 gezeigt, um das Steuergerät an dem Gehäuse 200 zu verschrauben. Diese Bohrungen 16 entsprechen den Bohrungen auf der in Fig. 2 gezeigten Seite, d.h. sie liegen an derselben Stelle wie die Bohrungen 16 in Fig. 2.

Bohrungen 16 mit zugehörigen Verschraubungen 30, siehe Figuren 5 bis 8, haben den Vorteil, dass sie wieder lösbar sind, d.h. dass das Steuergerät 10 austauschbar ist. Allerdings können auch andere Befestigungsmethoden angewendet werden, z.B. ein Verkleben. Die Art der Befestigung ist je nach Anwendung vom Fachmann zu wählen und nicht auf die genannten Arten beschränkt.

Wie in Figuren 5 bis 8 zu erkennen, ist an dem Bereich der Leiterplatte 11 des Steuergeräts 10, an dem die Elektronikkomponenten angeordnet sind, auf der Seite, die an der Gehäuseoberfläche 200 anliegt, eine Kühlplatte 12 integriert, die an eine metallische Fläche am Aggregat bzw. an der Gehäuseoberfläche 200 zur Abführung der Verlustwärme angeordnet ist. Die elektronischen Bauelemente können auf der Leiterplatte 11 einseitig oder doppelseitig bestückt werden. Abhängig von dem zur Verfügung stehenden Bauraum kann die Leiterplatte 11 über tiefengefräste Bereiche auch in verschiedenen Winkeln gebogen verbaut werden.

Figuren 5 und 6 zeigen jeweils eine Schnittdarstellung durch die Punkte A-A eines an der Außenseite eines Getriebegehäuses 200 verbauten Steuergeräts 10, wie bereits mit Bezug auf Figuren 2 bis 4 beschrieben, wobei gleiche Bezugszeichen dieselben Komponenten bezeichnen und hier nicht im Einzelnen detailliert wiederholt werden.

Die Pins 18 der Stecker 13, 14 sind direkt mit den korrespondierenden Leiterbahnen (nicht dargestellt) der Leiterplatte verbunden. Dadurch ergeben sich kurze Signalwege.

Fig. 5 zeigt die Ausführung, bei welcher der getriebeseitige Stecker 14 als runder Stecker ausgeführt ist und in die Öffnung des Gehäuses 201 eingepasst ist. Fig. 6 zeigt die Ausführung, bei welcher der getriebeseitige Stecker 14 dieselbe Ausführung aufweist wie der fahrzeugseitige Stecker 13, d.h. in diesem Fall länglich rechteckig, so dass beide Stecker innerhalb des Bereichs der Öffnung 201 im Gehäuse angeordnet sind, allerdings auf sich gegenüber liegenden Seiten des Steuergeräts 10.

Gezeigt sind in Figuren 5 und 6 zusätzlich Verschraubungen 30, welche durch die Bohrungen 16 auf der Ober- und Unterseite des Steuergeräts 10 durchgeführt sind und das Steuergerät 10 mit dem Gehäuse 200 verbinden. Die Art der Verschraubungen 30 kann beliebig gewählt werden, solange die gewünschte Verbindung zwischen Steuergerät 10 und Gehäuse 200 hergestellt wird.

Ferner ist in Fig. 5 zu sehen, dass die Dichtung 202 zwischen dem Stecker 14 und der Gehäusewand innerhalb der Öffnung 201 im Gehäuse angeordnet ist. In Fig. 6 ist die Dichtung 202 hingegen außerhalb der Öffnung 201 im Gehäuse angeordnet, da in dieser Ausführung kein runder Stecker verwendet wird, bei dem mit Hilfe eines oder mehrerer O-Ringe eine Abdichtung erfolgen kann. Wie oben beschrieben hängt die Wahl der Art der Dichtung 202 von der Art und Form des bzw. der Stecker ab.

Figuren 7 und 8 zeigen eine Schnittdarstellung durch die Punkte A-A eines an der Innenseite des Getriebegehäuses 200 verbauten Steuergeräts 10 gemäß einer alternativen Ausführung der vorliegenden Erfindung. Es werden dieselben Bezugszeichen für dieselben Komponenten wie für die vorherigen Figuren verwendet und deren Beschreibung nicht im Einzelnen detailliert wiederholt.

Im Unterschied zu dem in Figuren 5 und 6 gezeigten Ausführungsbeispiel wird in diesem Ausführungsbeispiel das Steuergerät 10 innerhalb des Gehäuses 200 angeordnet. Wie in Figuren 7 und 8 zu sehen ist, ist die Kühlplatte 12 wie auch in Figuren 5 und 6 auf der Seite des Steuergeräts angeordnet, die dem Gehäuse zugewandt ist, um die auf der Leiterplatte 11 angeordneten Elektronikkomponenten zu kühlen. Die Verschraubungen 30 sind wie in Figuren 5 und 6 ausgeführt, das heißt, sie sind durch Bohrungen durchgeführt, um das Steuergerät 10 mit dem Gehäuse zu verbinden. Der einzige Unterschied ist, dass die Verschraubungen 30 durch die Bohrungen 16 von der Innenseite des Gehäuses 200 erfolgen, wobei auch andere Verschraubungen gewählt werden könnten, die von der fahrzeugseitigen Seite verschraubt werden.

Wie ebenfalls vorher für den getriebeseitigen Stecker 14 beschrieben kann der fahrzeugseitige Stecker 13 durch die Öffnung 201 im Gehäuse 200 geführt werden und mit einer Dichtung 202, z.B. einem Formschluss oder einem bzw. mehreren O-Ringen, abgedichtet werden. Die Leiterplatte 11 kann ein- oder beidseitig mit Bauelementen bestückt sein und ist wie in den anderen Ausführungsbeispielen durch eine Umspritzung 17 vor äußeren Einflüssen geschützt.

In Fig. 7 ist ferner ein getriebeseitiger Stecker 14 gezeigt, wobei dieser in dieser Ausführung nicht unbedingt nötig ist. Vielmehr kann eine Anbindung der mit dem Steuergerät zu verbindenden Sensoren, Aktoren, etc. innerhalb des Getriebes direkt an der Leiterplatte z.B. durch Löten, Schweißen, Einpressen oder andere geeignete Verfahren erfolgen, wie in Fig. 8 gezeigt. Somit können Bauteile eingespart und ein kostengünstigeres System realisiert werden.

Bei den in Figuren 7 und 8 gezeigten Ausführungsbeispielen ist es auch möglich, den fahrzeugseitigen Stecker 13 wie in den vorherigen Ausführungsbeispielen nicht rund auszuführen, sondern z.B. rechteckig. Die Form des Steckers 13 ist nicht beschränkt, es kann jeder bzw. jede für die entsprechende Anwendung geeigneter Stecker 13 bzw. Steckerform verwendet werden. Sowohl in der Ausführung mit einem fahrzeugseitigen und einem getriebeseitigen Stecker 13 und 14, als auch in der Ausführung ohne den getriebeseitigen Stecker 14 können die bzw. der Stecker wie in Figuren 2 und 4 gezeigt innerhalb des Bereichs der Gehäuseöffnung 201 auf sich gegenüber liegenden Seiten angeordnet sein, um Platz zu sparen.

Die vorliegende Erfindung weist mehrere Vorteile gegenüber bekannten Steuergeräten beim Verbau an Gehäusen, insbesondere Getriebegehäusen, auf. Es können beispielsweise einfache, kostengünstige, nicht dichte Stecker mit Flachpins eingesetzt werden, oder zur Bereitstellung einer Öldichtheit eine Abdichtung der Pins 18 durch Duroplast-Umspritzung in Kombination mit einer Formdichtung oder einem oder mehreren O-Ringen erfolgen. Das heißt, es können sowohl axiale als auch radiale Dichtungen realisiert werden.

Ferner ist eine signifikante Einsparung von Einzelteilen bzw. eine Reduzierung der durch Zulieferer bereit gestellten Komponenten möglich, so dass wiederum Kosten eingespart werden können.

Zusätzlich wird eine Einsparung des Kabelsatzes zwischen der Verbindung Getriebe und angebauten Steuergerät ermöglicht, da hier Bahnen innerhalb der Leiterplatte als Verbindung dienen können.

Durch die Bauform kann eine optimale thermische Anbindung zur Wärmeableitung erreicht werden, da nur eine kleine Kühlfläche benötigt wird bzw. durch Tiefenfräsung teilweise eine Ausbildung von 3D-Strukturen möglich ist.

Durch die Option, dass das Steuergerät innerhalb des Getriebes verbaut werden kann, aber nicht muss, kann eine optimale Platzausnutzung erreicht werden. Es muss zum Beispiel im Getrieberaum kein weiterer Platz für die Elektronik vorgehalten werden, da diese im Steuergerät integriert ist, wobei das Steuergerät nur einen minimalen Bauraum benötigt.

### Bezugszeichen

- 10, 100: (Anbau-)Steuergerät
- 11: Leiterplatte
- 12: Kühlplatte
- 13: fahrzeugseitiger Stecker
- 14: getriebeseitiger Stecker
- 15: Versteifungsrippen
- 16: Anschraubpunkte
- 17: Umspritzung
- 18: Pins
- 200: Getriebegehäuse bzw. Wand des Getriebegehäuses
- 201: Öffnung im Getriebegehäuse für Getriebestecker
- 202: Dichtung
- 120: Getriebestecker
- 130: Stecksockel für fahrzeugseitige und getriebeseitige Stecker
- 123: Kabelsatz zum Getriebe
- 124: Kabelsatz zum Fahrzeug
- 30: Verschraubung

## Patentansprüche

1. Steuergerät (10), insbesondere Getriebesteuergerät (10), das dazu eingerichtet ist, auf einer Außenseite oder einen Innenseite eines Gehäuses (200), insbesondere eines Getriebegehäuses (200), an der Gehäuseoberfläche 200 anliegend befestigt zu werden, wobei das Steuergerät (10) eine Leiterplatte (11) sowie zumindest einen auf der Leiterplatte (11) angeordneten und mit seinen Pins (18) mit korrespondierenden Leiterbahnen der Leiterplatte verbundenen Stecker (13; 14) umfasst, der dazu eingerichtet ist, durch eine Öffnung (201) in dem Gehäuse (200) zu ragen und über an der Leiterplatte (11) angeordnete Leiterbahnen eine elektrische und/oder Signal-Verbindung zwischen der Außenseite und der Innenseite des Gehäuses (200) herzustellen, wobei eine Umspritzung (17) zumindest die Leiterplatte (11) und den bzw. die Stecker (13; 14) umgibt.

2. Steuergerät (10) nach Anspruch 1, wobei das Steuergerät (10) an der Außenseite des Gehäuses (200) angeordnet ist und der Stecker ein getriebeseitiger Stecker (14) ist.

3. Steuergerät (10) nach Anspruch 2, wobei die Leiterplatte (11) auf der dem getriebeseitigen Stecker (14) gegenüber liegenden Seite einen fahrzeugseitigen Stecker (13) aufweist, der über die Leiterbahnen mit dem getriebeseitigen Stecker (14) verbunden ist.

4. Steuergerät (10) nach Anspruch 1, wobei das Steuergerät (10) an der Innenseite des Gehäuses (200) angeordnet ist und der Stecker ein fahrzeugseitiger Stecker (13) ist.

5. Steuergerät (10) nach Anspruch 4, wobei die Leiterplatte (11) auf der dem fahrzeugseitigen Stecker (13) gegenüber liegenden Seite einen getriebeseitigen Stecker (14) aufweist, der über die Leiterbahnen mit dem fahrzeugseitigen Stecker (13) verbunden ist.

6. Steuergerät (10) nach Anspruch 4, wobei die mit dem fahrzeugseitigen Stecker (13) verbundenen Leiterbahnen der Leiterplatte (11) direkt mit getriebeseitigen Komponenten verbunden sind.

7. Steuergerät (10) nach Anspruch 6, wobei die Verbindung zwischen Leiterbahnen und Komponenten im Gehäuseinnenraum mittels Löten, Einpressen, Verschweißen erfolgt und/oder die Komponenten im Gehäuseinnenraum Signalanbindungen, insbesondere Busanbindungen, insbesondere von Sensoren, Aktoren, Ventile und/oder Motoren, und/oder eine Spannungs- bzw. Stromversorgung umfassen.

8. Steuergerät (10) nach einem der vorhergehenden Ansprüche, wobei den durch die Öffnung (201) des Gehäuses (200) ragenden Stecker (13; 14) eine Dichtung (202), insbesondere ein oder mehrere O-Ringe oder eine in einer Ausnehmung der Umspritzung (17) angeordnete Formdichtung, umgibt.

9. Steuergerät (10) nach einem der vorhergehenden Ansprüche, wobei die Leiterplatte (11) darauf angeordnete elektrische und/oder elektronische Bauelemente umfasst, und in dem Bereich der elektrischen und/oder elektronischen Bauelemente auf der Seite der Leiterplatte (11), die dem Gehäuse zugewandt ist, eine Kühleinrichtung (12), insbesondere eine Kühlplatte, angeordnet ist.

## Claims

1. Control device (10), in particular a transmission control device (10), which is designed to be fastened on an outer side or an inner side of a housing (200), in particular a transmission housing (200), so as to lie on the housing surface (200), wherein the control device (10) comprises a printed circuit board (11) and at least one plug (13; 14) which is arranged on the printed circuit board (11) and is connected by its pins (18) to corresponding conductor tracks of the printed circuit board, which plug is designed to project through an opening (201) in the housing (200) and, via conductor tracks arranged on the printed circuit board (11), to produce an electrical and/or signal connection between the outer side and the inner side of the housing (200), wherein an injection-moulded encapsulation (17) surrounds at least the printed circuit board (11) and the plug(s) (13; 14).

2. Control device (10) according to Claim 1, wherein the control device (10) is arranged on the outer side of the housing (200) and the plug is a transmission-side plug (14).

3. Control device (10) according to Claim 2, wherein the printed circuit board (11) has, on the side situated opposite to the transmission-side plug (14), a vehicle-side plug (13) which is connected to the transmission-side plug (14) via the conductor tracks.

4. Control device (10) according to Claim 1, wherein the control device (10) is arranged on the inner side of the housing (200) and the plug is a vehicle-side plug (13) .

5. Control device (10) according to Claim 4, wherein the printed circuit board (11) has, on the side situated opposite to the vehicle-side plug (13), a transmission-side plug (14) which is connected to the vehicle-side plug (13) via the conductor tracks.

6. Control device (10) according to Claim 4, wherein the conductor tracks of the printed circuit board (11) which are connected to the vehicle-side plug (13) are directly connected to transmission-side components.

7. Control device (10) according to Claim 6, wherein the connection between the conductor tracks and components in the housing interior occurs by means of soldering, press-fitting or welding and/or the components in the housing interior comprise signal connections, in particular bus connections, in particular of sensors, actuators, valves and/or motors, and/or a voltage or current supply.

8. Control device (10) according to one of the preceding claims, wherein the plug (13; 14) which projects through the opening (201) of the housing (200) is surrounded by a seal (202), in particular one or more O-rings or a moulded seal arranged in a recess of the injection-moulded encapsulation (17).

9. Control device (10) according to one of the preceding claims, wherein the printed circuit board (11) comprises electric and/or electronic components arranged thereon, and a cooling device (12), in particular a cooling plate, is arranged in the region of the electric and/or electronic components on that side of the printed circuit board (11) which faces the housing.

## Revendications

1. Contrôleur (10), notamment contrôleur de boîte de vitesses (10), lequel est conçu pour être fixé sur un côté extérieur ou un côté intérieur d'un boîtier (200), notamment d'un boîtier de boîte de vitesses (200), en reposant contre la surface du boîtier (200), le contrôleur (10) comportant un circuit imprimé (11) ainsi qu'au moins une fiche (13 ; 14), disposée sur le circuit imprimé (11) et reliée par ses broches (18) avec des pistes conductrices correspondantes du circuit imprimé, laquelle est adaptée pour faire saillie à travers une ouverture (201) dans le boîtier (200) et pour établir, par le biais des pistes conductrices disposées sur le circuit imprimé (11), une liaison électrique et/ou de signal entre le côté extérieur et le côté intérieur du boîtier (200), un surmoulage (17) entourant au moins le circuit imprimé (11) et la ou les fiches (13 ; 14).

2. Contrôleur (10) selon la revendication 1, le contrôleur (10) étant disposé sur le côté extérieur du boîtier (200) et la fiche étant une fiche côté boîte de vitesses (14).

3. Contrôleur (10) selon la revendication 2, le circuit imprimé (11) possédant, sur le côté qui se trouve à l'opposé de la fiche côté boîte de vitesses (14), une fiche côté véhicule (13) qui est reliée à la fiche côté boîte de vitesses (14) par le biais des pistes conductrices.

4. Contrôleur (10) selon la revendication 1, le contrôleur (10) étant disposé sur le côté intérieur du boîtier (200) et la fiche étant une fiche côté véhicule (13) .

5. Contrôleur (10) selon la revendication 4, le circuit imprimé (11) possédant, sur le côté qui se trouve à l'opposé de la fiche côté véhicule (13), une fiche côté boîte de vitesses (14) qui est reliée à la fiche côté véhicule (13) par le biais des pistes conductrices.

6. Contrôleur (10) selon la revendication 4, les pistes conductrices du circuit imprimé (11) qui sont reliées à la fiche côté véhicule (13) étant reliées directement à des composants côté boîte de vitesses.

7. Contrôleur (10) selon la revendication 6, la liaison entre les pistes conductrices et les composants à l'intérieur du boîtier s'effectuant par brasage, enfoncement, soudage et/ou les composants à l'intérieur du boîtier comprenant des connexions de signal, notamment des connexions de bus, notamment de capteurs, d'actionneurs, de vannes et/ou de moteurs, et/ou une alimentation en tension ou en courant.

8. Contrôleur (10) selon l'une des revendications précédentes, une garniture d'étanchéité (202), notamment un ou plusieurs joints toriques ou une garniture d'étanchéité moulée disposée dans un creux du surmoulage (17), entourant la fiche (13 ; 14) qui fait saillie à travers l'ouverture (201) du boîtier (200).

9. Contrôleur (10) selon l'une des revendications précédentes, le circuit imprimé (11) comportant des composants électriques et/ou électroniques disposés sur celui-ci et un dispositif de refroidissement (12), notamment une plaque de refroidissement, étant disposé dans la zone des composants électriques et/ou électroniques sur le côté du circuit imprimé (11) qui fait face au boîtier.
